# EUROPÄISCHE PATENTANMELDUNG

(11) **EP 1 711 043 A1**
(43) Veröffentlichungstag der Anmeldung: **11.10.2006**
(21) Anmeldenummer: 05007642.1
(22) Anmeldetag: 07.04.2005
(51) Int. Cl.: H05K 9/00

(54) **Gerät mit einer Anzeigeeinheit**

(71) Anmelder: Delphi Technologies, Inc., Troy, MI 48007 (US)
(72) Erfinder: Slawik, Ralf, 91126 Schwabach (DE)
(74) Vertreter: Manitz, Finsterwald & Partner GbR

(57) **Zusammenfassung**

Die Erfindung betrifft ein Gerät mit einer Anzeigeeinheit, einem metallischen Chassis, auf dem die Anzeigeeinheit gehaltert ist, und einem metallischen Schutzelement zur Ableitung elektrostatischer Aufladung, wobei das metallische Schutzelement mit dem Chassis direkt und ohne zusätzliche Kontaktelemente in leitendem Kontakt ist und/oder das metallische Schutzelement derart ausgestaltet und/oder angeordnet ist, dass es nur einen gegen elektrostatische Aufladung empfindlichen Bereich der Anzeigeeinheit schützt.

## Beschreibung

Die Erfindung betrifft ein Gerät mit einer Anzeigeeinheit, einem zumindest teilweise metallischen Chassis, an dem die Anzeigeeinheit gehaltert ist, und einem zumindest teilweise metallischen Schutzelement zur Ableitung elektrostatischer Aufladung.

Anzeigeeinheiten, insbesondere zum Beispiel LCD-Displays elektrischer bzw. elektronischer Geräte sind empfindlich gegen elektrostatische Aufladung, die zum Beispiel bei Berührung entstehen kann.

Bei bekannten Lösungen ist daher die Anzeigeeinheit von einer metallischen Abschirmung umgeben, so dass elektrostatische Aufladung abgeleitet wird. In der Regel werden die Anzeigeeinheit und die Abschirmung auf einer Leiterplatte montiert. Im Falle eines LCD-Displays wird dazu zunächst die Display-Beleuchtung auf der Leiterplatte angebracht. Im Anschluss wird das Display selbst auf der Leiterplatte montiert. In einem nächsten Schritt wird die Abschirmung an der Leiterplatte befestigt. Die Abschirmung und das Display werden auf der Leiterplatte verlötet.

Direkt oder über Kontakte der Leiterplatte wird ein Massekabel mit der Abschirmung verlötet.

Die so gebildete Einheit aus Leiterplatte, Display-Beleuchtung, Display-Abschirmung und Display wird in einer Blende fixiert, zum Beispiel der Frontblende eines Audiogerätes für das Armaturenbrett eines Kraftfahrzeuges. Die Blende mit den genannten Komponenten wird auf einem Chassis montiert. Mit dem metallischen Chassis wird schließlich das freie Ende des Massekabels verschraubt, so dass elektrostatische Aufladung von der Abschirmung des Displays über das Massekabel an das metallische Chassis des Gerätes abgeführt wird.

Aufgabe der vorliegenden Erfindung ist es, ein Gerät anzugeben, bei dem die Montage einfacher ist und das dennoch einen wirkungsvollen Schutz gegen elektrostatische Aufladung bietet.

Diese Aufgabe wird mit einem Gerät mit den Merkmalen des Anspruchs 1 oder ein Gerät mit den Merkmalen des Anspruchs 2 gelöst. Bevorzugte Ausgestaltungen sind Gegenstand von Unteransprüchen.

Ein erfindungsgemäßes Gerät weist bei einer ersten Ausführung ein zumindest teilweise metallisches Schutzelement auf, das mit dem Chassis direkt und ohne zusätzliche Kontaktelemente in leitender Verbindung steht. Bei dieser erfindungsgemäßen Lösung ist ein zusätzliches Massekabel zur Verbindung der Abschirmung mit dem Chassis nicht mehr notwendig. Das Schutzelement selbst ist in direktem Kontakt mit dem Chassis, so dass die Montage stark vereinfacht ist.

Besonders einfach ist die Montage einer Ausgestaltung, wenn das metallische Schutzelement fest mit einer Blende verbunden ist, die auch von dem Chassis gehaltert wird. Bei dieser Ausgestaltung wird bei Montage der Blende automatisch das metallische Schutzelement in Position gebracht und muss nicht zusätzlich positioniert werden.

Eine sichere Ableitung elektrostatischer Aufladung ist gewährleistet, wenn das metallische Schutzelement wenigstens einen Bereich mit federnden Eigenschaften aufweist, der es bei auf dem Chassis montierter Blende gegen das Chassis mechanisch vorspannt. Durch die mechanische Vorspannung ist gewährleistet, dass das metallische Schutzelement mit dem Chassis in sicherer Verbindung steht.

Unabhängiger Schutz wird für ein Gerät beansprucht, bei dem das zumindest teilweise metallische Schutzelement derart ausgestaltet und/oder angeordnet ist, dass es nur einen gegen elektrostatische Aufladung empfindlichen Teil der Anzeigeeinheit schützt. Ein solches Gerät ist kompakt im Aufbau, da eine vollständige metallische Abschirmung der Anzeigeeinheit vermieden wird. Nur diejenigen Bereiche, die von der elektrostatischen Aufladung besonders gefährdet sind, also zum Beispiel der Anschlussbereich der Anzeigeeinheit, werden durch das metallische Schutzelement geschützt.

Eine besonders einfach zu montierende und kompakte Bauform lässt sich mit einem Gerät erreichen, bei dem das zumindest teilweise metallische Schutzelement direkt und ohne zusätzliche Kontaktelemente mit dem Chassis in leitender Verbindung steht und außerdem derart angeordnet und/oder ausgestaltet ist, dass es nur einen gegen elektrostatische Aufladung besonders empfindlichen Bereich schützt.

Besonders effektiv ist der Schutz gegen elektrostatische Aufladung, wenn das metallische Schutzelement einen flachen langgestreckten Bereich umfasst, der vor dem gegen elektrostatische Aufladung empfindlichen Bereich der Anzeigeeinheit angeordnet ist. Ein solches flaches metallisches Element lässt sich zum Beispiel einfach stanzen und in die gewünschte Form biegen.

Besonders gut zum Tragen kommt die einfache Montage bzw. der kompakte Aufbau bei einem Gerät, bei dem das Chassis eine metallische Platte umfasst, gegen die zum Beispiel ein federndes metallisches Schutzelement vorgespannt sein kann.

An dem Chassis kann zumindest ein Element vorgesehen sein, mit dem das metallische Schutzelement im montierten Zustand über eine entsprechende Kontaktlasche in Kontakt ist, zum Beispiel daran anliegt. Bei dem Element des Chassis kann es sich um eines von mehreren Halteelementen, zum Beispiel Rastelementen des Chassis handeln, die zur Montage des Chassis in der Blende oder mit einer Leiterplatte vorgesehen sind.

Besonders gefährdet gegen elektrostatische Aufladung sind LCD-Displays, so dass sich die Erfindung besonders für Geräte mit solchen Displays eignet.

Die Erfindung wird anhand der beiliegenden Figuren im Detail erläutert, die eine beispielhafte Ausführungsform darstellen. Dabei zeigt
- Fig. 1: eine Ansicht des Frontbereiches eines Audiogerätes,
- Fig. 2a bis 2d: einzelne Komponenten des Audiogerätes der Fig. 1,
- Fig. 3: ein metallisches Schutzelement,
- Fig. 4: eine schematische Teilinnenansicht zur Erläuterung, und
- Fig. 5: eine Teilansicht auf die Rückseite einer Blende.

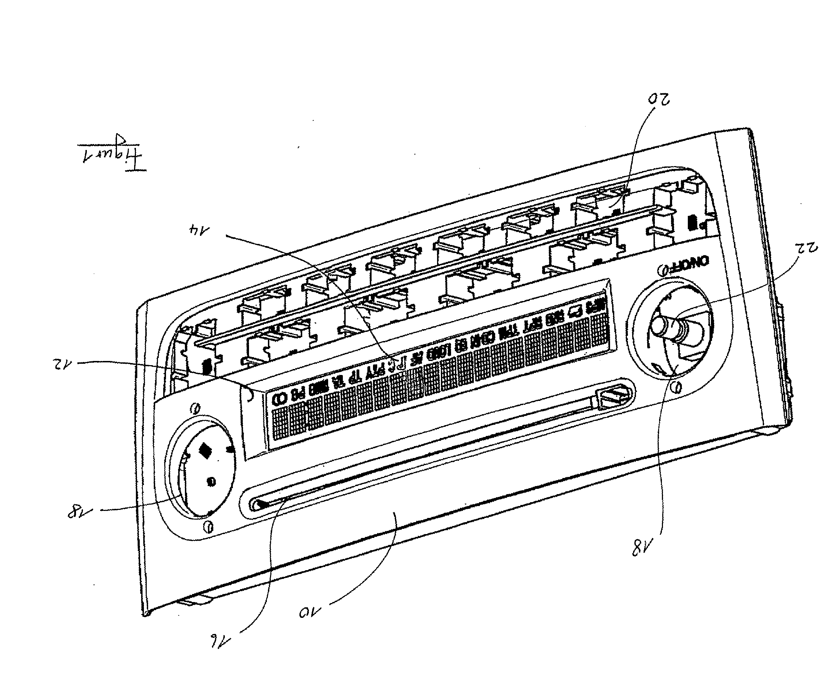

In Fig. 1 ist die Vorderseite eines Kraftfahrzeugaudiogerätes erkennbar, wie es zum Beispiel in ein Armaturenbrett eingebaut wird. Die Ansicht zeigt die Vorderseite in teilweise montiertem Zustand. Erkennbar ist die Blende 10 mit einer Öffnung 12, durch die ein LCD-Display 14 sichtbar ist. Die Blende 10 weist weiterhin einen Schlitz 16 zum Durchführen einer Kompaktdisk (CD) in eine hinter der Blende angeordnete CD-Abspieleinheit auf. Öffnungen 18 dienen zur Durchführung von Reglerknöpfen, zum Beispiel eines Potentiometers 22. Im endgültig eingebauten Zustand wird auf das Potentiometer 22 in an sich bekannter Weise ein Drehknopf aufgesteckt. Die Blende weist weiterhin Öffnungen 20 auf, durch die Taster geführt werden können, die in an sich bekannter Weise zur Bedienung des Audiogerätes dienen.

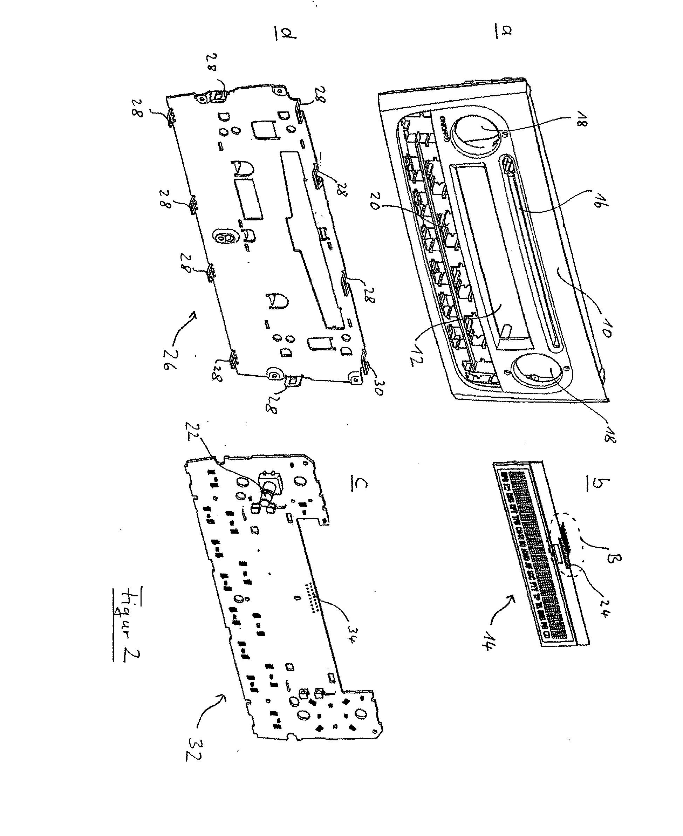

Fig. 2 zeigt einzelne Komponenten des vorderen Bereiches des Audiogerätes in Einzeldarstellung. Dabei stellt Fig. 2a die vordere Blende dar, die zum Beispiel aus Kunststoff gefertigt ist. Fig. 2b zeigt das dahinter angeordnete LCD-Display 14 mit elektrischen Anschlüssen 24, mit deren Hilfe das LCD-Display angesteuert werden kann. Der Bereich B deutet jenen Teil des Displays 14 an, der besonders empfindlich gegen elektrostatische Aufladung ist, hier den Bereich mit den elektrischen Anschlüssen 24.

Fig. 2c zeigt eine Leiterplatte, mit deren Hilfe die elektrischen Anschlüsse der Komponenten der Vorderseite des Audiogerätes kontaktiert werden können. Insbesondere weist die Leiterplatte 32 Anschlussöffnungen 34 auf, durch die die Anschlüsse 24 des Displays 14 gesteckt und verlötet werden können. Auf der Leiterplatte 32 ist u.a. auch das Potentiometer 22 befestigt. Andere Anschlüsse der Leiterplatte 32 zum Anschluss von Schaltern oder anderen elektronischen Einheiten sind in an sich bekannter Weise vorgesehen und werden hier nicht gesondert erläutert.

Fig. 2d zeigt ein Chassis 26, bei der gezeigten Ausführungsform in der Form einer Stirnplatte. Das Chassis 26 ist metallisch und weist ebenfalls metallische Halteelemente 28, 30 auf, die der Befestigung der Leiterplatte 32 an dem Chassis 26 dienen und zum Beispiel Rastelemente umfassen, in die bzw. zwischen die die Leiterplatte 32 geklemmt werden kann.

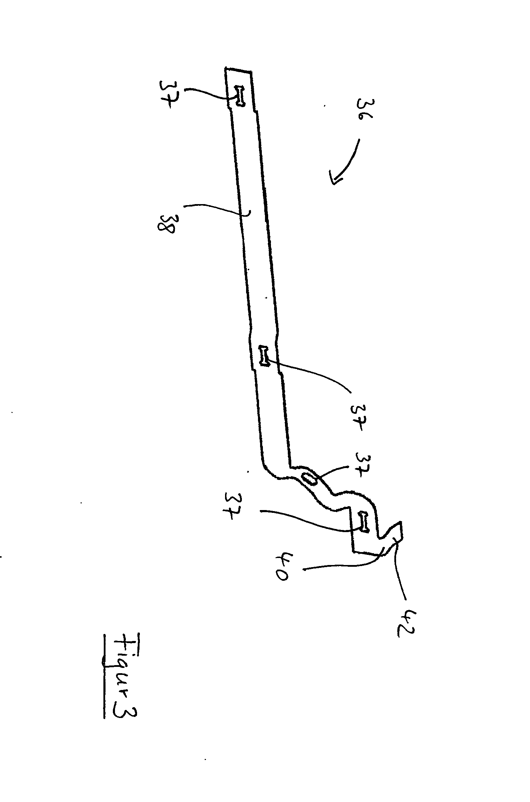

Fig. 3 zeigt ein metallisches Schutzelement 36, das zum Schutz des Displays 14 vor elektrostatischer Aufladung dient, wie weiter unten erläutert werden wird. Das metallische Schutzelement 36 ist zum Beispiel aus Stahl gefertigt und weist einen langgestreckten Bereich 38 und einen federnden Bereich 40 auf. Mit dem Bezugszeichen 42 ist eine Kontaktlasche bezeichnet, die in noch zu erläuternder Weise mit einem Halteelement 30 des Chassis 26 zusammenwirkt. Bezugsziffern 37 bezeichnen Rastöffnungen zur Befestigung des metallischen Schutzelementes 36 an Rasthaken 44 der Blende 10.

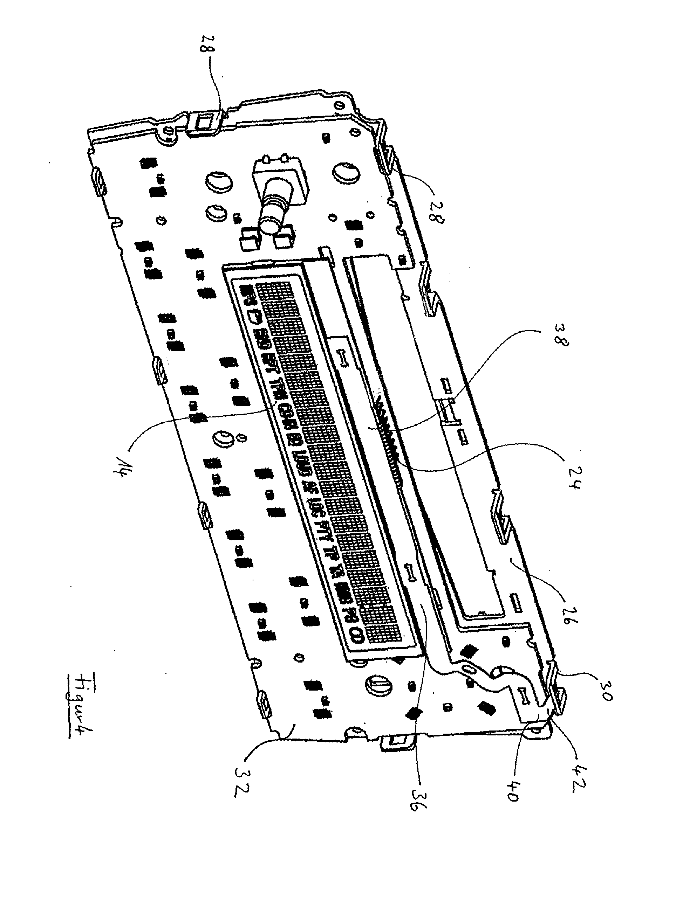

Fig. 4 zeigt das Chassis 26 zusammen mit der aufgesteckten Leiterplatte 32, die von den Halteelementen 28, 30 gehalten wird. Dargestellt ist außerdem das Display 14, dessen Anschlüsse 24 durch die Aufnahmen 34 der Leiterplatte 32 gesteckt und dort verlötet sind, wobei dies in der Ansicht der Fig. 4 nicht erkennbar ist. Vor den Anschlüssen 24 befindet sich der langgestreckte Teil 38 des metallischen Schutzelementes 36. Die Kontaktlasche 42 des metallischen Schutzelementes 36 liegt an einem Halteelement 30 des metallischen Chassis 26 an und ist gegen das Chassis mechanisch vorgespannt. Zwischen dem Chassis 26 und dem metallischen Schutzelement 36 besteht damit eine elektrisch leitende Verbindung. Die Form des metallischen Schutzelementes 36 ist so gewählt, dass sich ein Abstand von ca. 1 bis 2 mm zwischen dem langgestreckten Bereich 38 des metallischen Schutzelementes 36 und den Anschlüssen 24 des Displays 14 einstellt. Nicht gezeigt ist die Blende 10, die vor den dargestellten Komponenten angeordnet ist und an der das metallische Schutzelement 36 in der weiter unten geschilderten Weise befestigt ist.

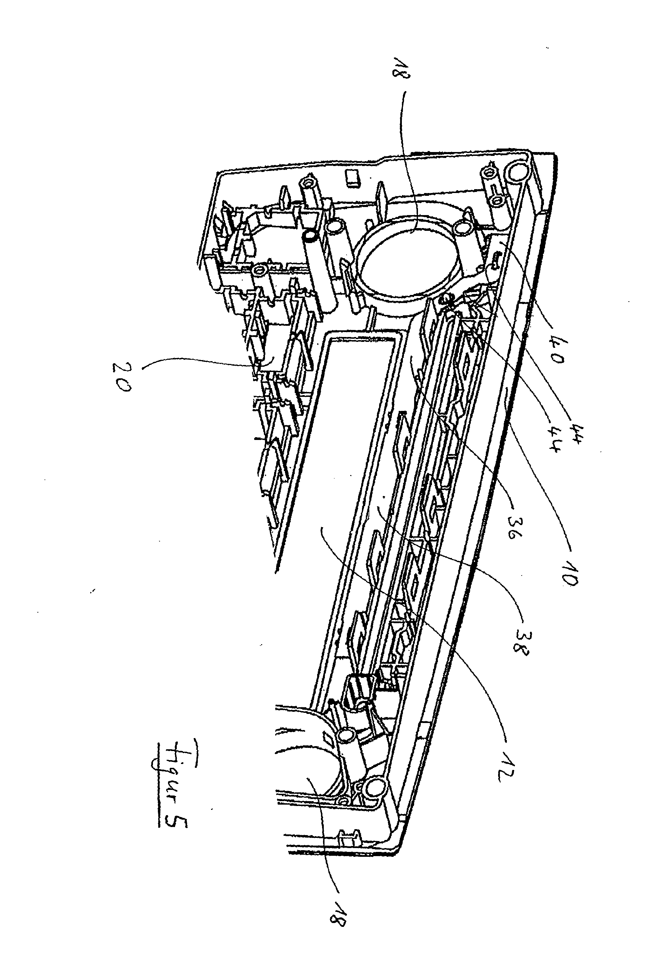

Fig. 5 zeigt den relevanten Teil der Rückansicht der Blende 10. In der Blende 10 ist mit Hilfe von Rasthaken 44, von denen in der Fig. 5 zwei erkennbar sind, das metallische Schutzelement 36 befestigt, das dazu korrespondierende Rastöffnungen 37 aufweist. Alternativ kann das metallische Schutzelement 36 zum Beispiel auch in die Rückseite 10 der Blende eingeklebt sein.

Die Anordnung des metallischen Schutzelements 36 in der Rückseite der Blende 10 ist dabei derart, dass bei Montage der Blende auf dem Chassis 26 das metallische Schutzelement 36 in der in Fig. 4 gezeigten Lage bezüglich des Chassis 26 zu liegen kommt und die Kontaktlasche 42 mit dem Halteelement 30 in Kontakt ist.

Die geschilderten Elemente werden wie folgt montiert und eingesetzt. Zunächst wird in an sich bekannter Weise eine Display-Beleuchtung auf der Leiterplatte 32 befestigt, wobei dieser Schritt nicht in den Figuren dargestellt ist. Auf der Leiterplatte 32 wird dann das Display 14 montiert, indem die Anschlüsse 24 durch die Öffnungen 34 der Leiterplatte 32 hindurch gesteckt und verlötet werden.

Im darauffolgenden Schritt wird die Leiterplatte 32 zusammen mit dem Display 14 in der Blende 10 befestigt.

Die Blende 10 ist dabei bereits mit dem metallischen Schutzelement 36 versehen, wie es in Fig. 5 dargestellt ist. Die entsprechende Montage des metallischen Schutzelements 36 in der Blende 10 kann zum Beispiel bereits im vorhinein geschehen sein, so dass die Einheit aus Blende 10 und metallischem Schutzelement 36 als ein Teil geliefert werden.

Durch die Montage der Einheit aus Leiterplatte 32 und Display 14 einerseits mit der Einheit aus Blende 10 und metallischem Schutzelement 36 andererseits kommt das metallische Schutzelement 36 bezüglich des Displays 14 in eine Lage, wie sie in Fig. 4 gezeigt ist. Insbesondere ist der langgestreckte Bereich 38 des metallischen Schutzelements 36 vor den elektrischen Anschlüssen 24 des Displays 14 angeordnet.

Die so gebildete Einheit aus Blende 10, metallischem Schutzelement 36, Display 14 und Leiterplatte 32 wird dann auf das Chassis 26 montiert, indem die Leiterplatte 32 zwischen die Halteelemente 28, 30 eingerastet wird. Dabei tritt die Kontaktlasche 42 des metallischen Schutzelementes 36 ohne zusätzliche Maßnahmen mit einem Halteelement 30 des metallischen Chassis 26 in Kontakt, so dass eine leitende Verbindung entsteht.

Es wird also ohne zusätzliche Maßnahmen ein Schutz gegen elektrostatische Aufladung für das Display zur Verfügung gestellt, wobei kein Massekabel oder ähnliches montiert oder festgelötet werden müsste.

Die so fertiggestellte Fronteinheit kann dann in an sich bekannter Weise zur weiteren Montage des Audiogerätes verwendet werden.

### Bezugszeichenliste

- 10: Blende
- 12: Öffnung in der Blende für die Displayanzeige
- 14: Display
- 16: CD-Schlitz in der Blende
- 18: Öffnungen für Regler
- 20: Öffnungen für Taster
- 22: Potentiometer
- 24: elektrische Display-Anschlüsse
- 26: Chassis, Stirnplatte
- 28: Halteelemente
- 30: Halteelement
- 32: Leiterplatte
- 34: Aufnahme für elektrische Display-Anschlüsse
- 36: metallisches Schutzelement
- 37: Rastöffnung
- 38: langgestreckter Bereich
- 40: federnder Bereich
- 42: Kontaktlasche
- 44: Rasthaken

- B: empfindlicher Bereich des Displays

## Patentansprüche

1. Gerät mit
- einer Anzeigeeinheit (14),
- einem zumindest teilweise metallischen Chassis (26), an dem die Anzeigeeinheit (14) gehaltert ist, und
- einem zumindest teilweise metallischen Schutzelement (36) zur Ableitung elektrostatischer Aufladung,
wobei das zumindest teilweise metallische Schutzelement (36) mit dem Chassis (26) direkt und ohne zusätzliche Kontaktelemente in elektrisch leitendem Kontakt ist.

2. Gerät, insbesondere nach Anspruch 1, mit
- einer Anzeigeeinheit (14),
- einem zumindest teilweise metallischen Chassis (26), an dem die Anzeigeeinheit (14) gehaltert ist, und
- einem zumindest teilweise metallischen Schutzelement zur Ableitung elektrostatischer Aufladung,
wobei das zumindest teilweise metallische Schutzelement (36) derart ausgestaltet und/oder angeordnet ist, dass es im Wesentlichen nur einen gegen elektrostatische Aufladung empfindlichen Teil (24) der Anzeigeeinheit (14) schützt.

3. Gerät nach einem der Ansprüche 1 oder 2, mit einer Blende (10), die wenigstens einen offenen oder transparenten Bereich (12) aufweist, durch den die Anzeige der Anzeigeeinheit (14) sichtbar ist, wobei auf dem Chassis (26) die Anzeigeeinheit (14) und die Blende (10) gehaltert sind.

4. Gerät nach Anspruch 3, bei dem das zumindest teilweise metallische Schutzelement (36) fest mit der Blende (10) verbunden ist.

5. Gerät nach einem der Ansprüche 1 bis 4, bei dem das zumindest teilweise metallische Schutzelement (36) wenigstens einen Bereich (40) mit federnden Eigenschaften aufweist, der es gegen das Chassis (26) mechanisch vorspannt.

6. Gerät nach einem der Ansprüche 1 bis 5, bei dem das zumindest teilweise metallische Schutzelement (36) einen flachen lang gestreckten Bereich (38) umfasst, der vor einem gegen elektrostatische Aufladung empfindlichen Teil (24) der Anzeigeeinheit (14) angeordnet ist.

7. Gerät nach einem der Ansprüche 1 bis 6, bei dem das zumindest teilweise metallische Schutzelement (36) die elektrischen Anschlüsse (24) zur Ansteuerung der Anzeigeeinheit (14) schützt.

8. Gerät nach einem der Ansprüche 1 bis 7, bei dem das Chassis (26) eine metallische Platte umfasst.

9. Gerät nach einem der Ansprüche 1 bis 8, bei dem die Anzeigeeinheit (14) ein LCD-Display umfasst.

10. Gerät nach einem der Ansprüche 1 bis 9, bei dem es sich um ein elektronisches Gerät zum Einbau in ein Kraftfahrzeug handelt, vorzugsweise zum Einbau in das Armaturenbrett.

## Geänderte Patentansprüche

### Geänderte Patentansprüche gemäss Regel 86(2) EPÜ.

**1.** Gerät mit
- einer Anzeigeeinheit (14),
- einem zumindest teilweise metallischen Chassis (26), an dem die Anzeigeeinheit (14) gehaltert ist, und
- einem zumindest teilweise metallischen Schutzelement zur Ableitung elektrostatischer Aufladung,
das derart ausgestaltet und/oder angeordnet ist, dass es im Wesentlichen nur einen gegen elektrostatische Aufladung empfindlichen Teil (24) der Anzeigeeinheit (14) schützt, und
einen flachen lang gestreckten Bereich (38) umfasst, der vor einem gegen elektrostatische Aufladung empfindlichen Teil (24) der Anzeigeeinheit (14) angeordnet ist.

**2.** Gerät nach Anspruch 1, bei dem das zumindest teilweise metallische Schutzelement (36) mit dem Chassis (26) direkt und ohne zusätzliche Kontaktelemente in elektrisch leitendem Kontakt ist.

**3.** Gerät nach einem der Ansprüche 1 oder 2, mit einer Blende (10), die wenigstens einen offenen oder transparenten Bereich (12) aufweist, durch den die Anzeige der Anzeigeeinheit (14) sichtbar ist, wobei auf dem Chassis (26) die Anzeigeeinheit (14) und die Blende (10) gehaltert sind.

**4.** Gerät nach Anspruch 3, bei dem das zumindest teilweise metallische Schutzelement (36) fest mit der Blende (10) verbunden ist.

**5.** Gerät nach einem der Ansprüche 1 bis 4, bei dem das zumindest teilweise metallische Schutzelement (36) wenigstens einen Bereich (40) mit federnden Eigenschaften aufweist, der es gegen das Chassis (26) mechanisch vorspannt.

**6.** Gerät nach einem der Ansprüche 1 bis 5, bei dem das zumindest teilweise metallische Schutzelement (36) die elektrischen Anschlüsse (24) zur Ansteuerung der Anzeigeeinheit (14) schützt.

**7.** Gerät nach einem der Ansprüche 1 bis 6, bei dem das Chassis (26) eine metallische Platte umfasst.

**8.** Gerät nach einem der Ansprüche 1 bis 7, bei dem die Anzeigeeinheit (14) ein LCD-Display umfasst.

**9.** Gerät nach einem der Ansprüche 1 bis 8, bei dem es sich um ein elektronisches Gerät zum Einbau in ein Kraftfahrzeug handelt, vorzugsweise zum Einbau in das Armaturenbrett.
